# EUROPEAN PATENT SPECIFICATION

(11) **EP 0 531 128 B1**
(45) Date of publication and mention of the grant of the patent: **01.12.1999**
(21) Application number: 92307992.5
(22) Date of filing: 03.09.1992
(51) Int. Cl.: H01L 23/525

(54) **Semiconductor device with fuse**
Halbleiteranordnung mit Schmelzsicherung
Dispositif semi-conducteur comprenant un fusible

(30) Priority: 04.09.1991 JP 22420791
(43) Date of publication of application: 10.03.1993
(73) Proprietor: FUJITSU LIMITED, Kawasaki-shi, Kanagawa 211 (JP)
(72) Inventor: Endo, Toru, Fujitsu Limited, Kawasaki-shi, Kanagawa 211 (JP); Okajima Yoshinori Fujitsu Limited, Kawasaki-shi, Kanagawa 211 (JP)
(74) Representative: Rackham, Stephen Neil

(56) References cited:
- EP-A- 0 025 347
- EP-A- 0 076 967
- EP-A- 0 112 693
- EP-A- 0 241 046
- PATENT ABSTRACTS OF JAPAN vol. 9, no. 248 (E-347)4 October 1985 & JP-A-60 098 664 ( MITSUBISHI ) 1 June 1985

## Description

The present invention relates to a semiconductor device (e.g., memory device) including fuses used for redundant circuitry or programming. For example, fuses are formed in a decoder of a static random-access memory (SRAM).

A fuse of the semiconductor device is blown as needed using an electric current pulse or laser for replacing a defective circuit with a redundant circuit or for programming (writing) information in a memory cell. A partial structure of the semiconductor device including a fuse has been designed to prevent an electric short-circuit between a semiconductor substrate and a circuit including the fuse from occurring and to prevent moisture from entering into an interior of the device from the atmosphere.

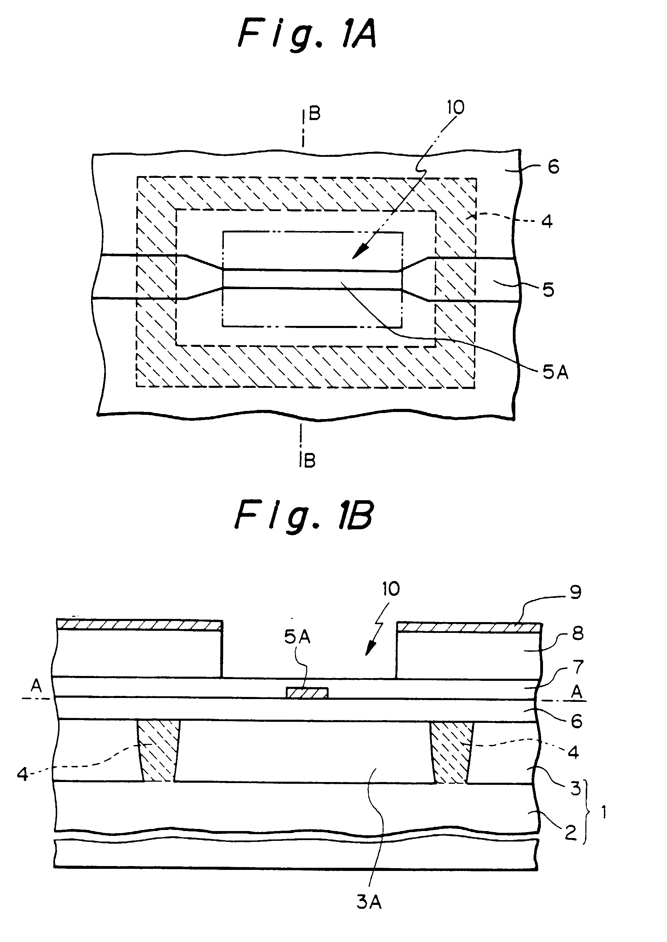

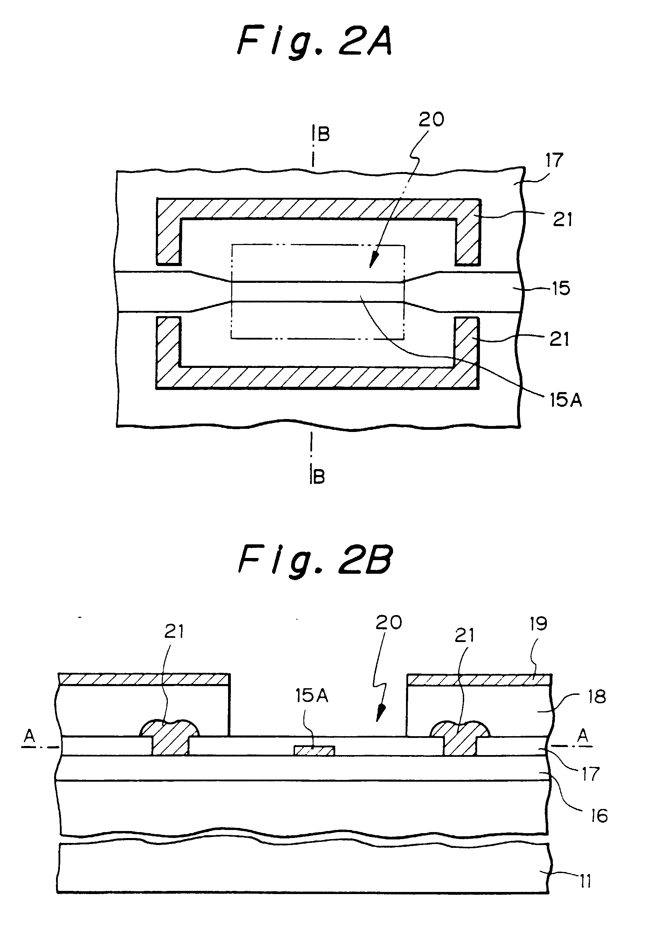

Two conventional semiconductor devices with a fuse are now explained with reference to Figs. 1A, 1B, 2A and 2B, respectively.

As shown in Figs. 1A and 1B, a portion of a first conventional semiconductor device including a fuse comprises a semiconductor substrate 1 consisting of a p-type silicon base substrate 2 and an n-type epitaxial silicon layer 3 formed thereon. In the epitaxial layer 3 a p-type isolation region 4 of a rectangular ring (Fig. 1A) is formed to extend in the base substrate 2, so that a portion 3A of the epitaxial layer below a narrow blowable portion 5A of a fuse 5 is isolated from the base substrate 2 and the other portion of the epitaxial layer 3. On the substrate 1 (i.e., the epitaxial layer 3) a field oxide layer 6 of SiO₂ is formed. The fuse 5 of polycrystalline silicon, aluminum or another metal is formed on the field oxide layer 6 and has the narrow portion 5A (Fig. 1A) to be blown. An insulating layer 7 of, e.g., PSG (phosphosilicate class) is formed over the fuse 5 and the field oxide layer 6 for isolating lower interconnections (conductive lines) including the fuse from upper interconnections. Furthermore, a passivation layer 8 of, e.g., PSG is formed on the insulating layer 7, and a nitride layer 9 of, e.g., Si₃N₄ is formed on the passivation layer 8. Since the passivation PSG layer 8 has hygroscopicity (i.e., low moisture-resistance), the nitride layer 9 having a high moisture-resistance prevents moisture from penetrating into the semiconductor device. The layers 9 and 8 are selectively etched to form an opening 10 above the narrow portion 5A.

As the occasion demands, the narrow portion 5A of the fuse 5 is irradiated with a laser beam through the opening 10, or a pulse current is fed through the fuse 5, so as to blow the fuse 5 by breaking the narrow portion 5A. The opening 10 facilitates the breaking of the narrow portion, and the insulating layer 7 prevents the broken portion from splashing.

When fusing, the broken portion of the fuse 5 may cause damage (cracks) to the field oxide layer 6 to extend into the epitaxial layer 3, so that there is a short circuit between the fuse 5 and the epitaxial layer 3 causing trouble. The isolation region 4 is formed to prevent the short from causing trouble.

As shown in Figs. 2A and 23, a portion cf a second conventional semiconductor device including a fuse comprises a semiconductor substrate 11 and a field oxide layer 16 of SiO₂ formed on the substrate. The substrate 11 may consist of a silicon base substrate and an epitaxial layer formed thereon. A fuse 15 with a narrow blowable portion 15A is made of polycrystalline silicon, aluminum or another metal is formed on the field oxide layer 16. An insulating layer of, e.g., PSG is formed over the fuse 15 and the field oxide layer 16 for isolating lower interconnections (conductive lines) including the fuse from upper interconnections. The insulating layer 17 is selectively etched to form a groove surrounding the narrow portion 15A except for two portions corresponding to the fuse 15. A metal guard ring 21 of, e.g., aluminum is formed to overfill the groove and come into contact with the field oxide layer 16. The guard ring 21 is separated into two portions, as shown in Fig. 2A.

As mentioned in the first conventional device, a passivation layer 18 of, e.g., PSG is formed over the metal guard ring 21 and the insulating layer 17, and a nitride layer 19 of, e.g., Si₃N₄ is formed on the passivation layer 18. The layers 19 and 18 are selectively etched to form an opening 20 above the narrow portion 15A. The fuse 15 is blown by breaking the narrow portion 15A with a laser beam or a pulse current. Of course, some of a number of the fuses are selectively blown in accordance with demands, while the majority of the fuses are not blown.

Since portions of the insulating 17 and the passivation layer 18 are exposed in the opening 20, moisture penetrates into the inside of the device through the layers 17 and 18. To prevent the moisture penetration, the metal guard ring 21 is formed to vertically extend through the insulating layer 17 and to separate a portion of the layer 17 near the narrow portion 15A from the rest thereof.

However, in the first conventional semiconductor device (Figs. 1A and 1B), the moisture penetrates into the inside of the device through the insulating layer 7 and an interface between the layers 7 and 8 from the exposed portion thereof in the opening 10. The moisture in the inside deteriorates aluminum interconnections (lines) and active elements (e.g., transistors) of the device. Furthermore, when the cracks of the insulating layer 6 and the passivation layer 7 are caused by flowing the fuse 5, moisture may penetrate through interfaces between the layers 6 and 7 and between the epitaxial layer 3 and the layer 6 from the cracks. In the second conventional semiconductor device (Figs. 2A and 2B), when flowing the fuse 15, cracks in the layers 16 and 17 may be caused to generate trouble, such as a short circuit or moisture penetration.

The nitride layer 9 (or 19) of the first (or second) semiconductor device is formed to protect the passivation PSG layer 8 (or 18) except for the opening 10 (or 20), so that a side of the layer 8 (or 18) and a portion of the layer 7 (or 17) are exposed in the opening. Therefore, the nitride layer does not sufficiently contribute to improving the moisture-resistance of the semiconductor device.

From EP-A-0,076,967 a semiconductor device with a fuse is known, in which the fuse is surrounded by a metal guard ring extending to the silicon substrate where it contacts an isolation region of a conductivity type opposite to that of the substrate.

From JP-A-60,098,664 it is know to protect fuses in a semiconductor device by a trench isolation layer formed in the silicon substrate and surrounding the fuse.

The document EP-A-0 025 347 describes a semiconductor device with fuses comprising:
a semiconductor substrate;
a field oxide layer formed on said semiconductor substrate;
a plurality of fuses formed on said field oxide layer each fuse having a blowable narrow portion;
an insulating layer over said fuses and said field oxide layer;
a passivation layer formed on said insulating layer, the insulating layer and the passivation layer which may be formed of silicon dioxide, silicon nitride or phosphosilicate glass having an opening above narrow portions of said fuses; and
a nitride layer formed on said passivation layer to cover the whole surface of the device after fuses have been blown.

According to the present invention, a semiconductor device with a fuse comprises:
a silicon substrate;
a field oxide layer formed on said silicon substrate;
a fuse being a conductor formed on said field oxide layer and having a blowable narrow portion;
an insulating layer of silicon oxide or phosphosilicate glass formed over said fuse and said field oxide layer to isolate said fuse from higher level conductors;
a phosphosilicate glass passivation layer formed on said insulating layer and having an opening above said fuse;
a silicon nitride layer formed on said passivation layer which completely covers the sidewall of said opening in said passivation layer and an interface between the insulating layer and said passivation layer so as to leave an opening above said blowable narrow fuse portion which is smaller than the opening in the passivation layer; and,
a guard ring formed of an electrically conductive material which surrounds said blowable narrow portion of said fuse, and is formed under said passivation layer to extend from said passivation layer to said silicon substrate through said insulating layer and said field oxide layer without making electrical contact to the fuse, wherein an isolation region of a conductivity type opposite to that of the surrounding silicon substrate or a trench isolation layer of an insulator is formed in the silicon substrate so as to completely surround and isolate a portion of said silicon substrate below said blowable narrow portion, whereby said guard ring is in direct contact with and vertically overlaps said isolation region.

The present invention will be more apparent from the description of the preferred embodiments set forth below, with reference to the accompanying drawings, in which:
Fig. 1A is a schematic plane view of a first conventional semiconductor device of which an insulation layer, a passivation layer and a nitride layer are removed;
Fig. 1B is a schematic sectional view of the first conventional semiconductor device taken along line B-B of Fig. 1A;
Fig. 2A is a schematic plane view of a second conventional semiconductor device of which an insulating layer, a nitride layer and a portion of a passivation layer are removed;
Fig. 2B is a schematic sectional view of the second conventional semiconductor device taken along line B-B of Fig. 2A;
Fig. 3A is a schematic plan view of a semiconductor device according to a first embodiment of the present invention of which a passivation layer, a nitride layer and a portion of an insulating layer are removed;
Fig. 3B is a schematic sectional view of the second conventional semiconductor device taken along line B-B of Fig. 3A; and
Fig. 4 is a schematic sectional view of a semiconductor device with a trench isolation layer according to another embodiment of the present invention.

### First Embodiment

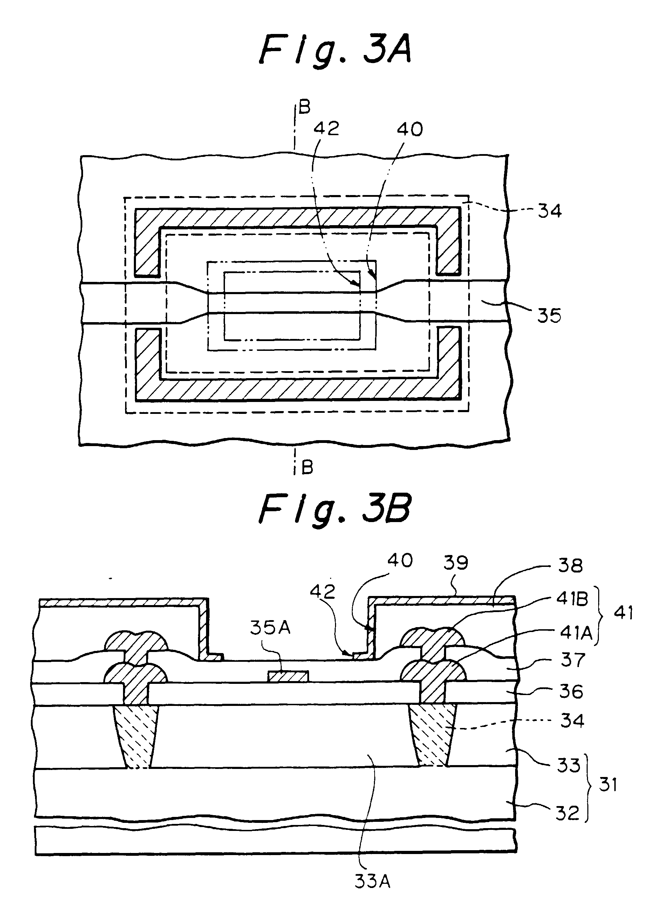

Referring to Figs. 3A and 3B, a portion of a semiconductor device according to a first embodiment of the present invention including a fuse comprises a semiconductor substrate 31 consisting of a p-type silicon base substrate 32 and an n-type epitaxial silicon layer 33 formed thereon. In the epitaxial layer 33 a p-type isolation region 34 of a rectangular ring (Fig. 3A) is formed by doping acceptor impurities therein to extend into the base substrate 32, so that a portion 33A of the epitaxial layer 33 below a narrow blowable portion 35A of a fuse is isolated from the base substrate 32 and the other portion of the epitaxial layer 33 in a manner similar to that of the first conventional semiconductor device. A field oxide layer 36 of SiO₂ is formed on the epitaxial layer 33 by, e.g., thermally oxidizing the silicon layer 33.

A polycrystalline silicon layer is deposited on the field oxide layer 36 by a chemical vapor deposition (CVD) process and is patterned by lithography to form a fuse 35 having the narrow portion 35A. The field oxide layer 36 is selectively etched by lithography to form groove surrounding the narrow portion 35A except for two portions under the fuse 35 at the isolation region 34.

A first metal guard ring 41A of, e.g., aluminum is formed by depositing a metal layer and selectively etching it to come into contact with the isolation region 34. It is preferable that the formation of the first guard metal ring 41A is carried out at the same time at which the (lower) interconnections (conductive lines) are formed. It is possible that the fuse 35 is made of metal, such as aluminum (Al), tungsten (W), tungsten silicide (WSi), titanium (Ti) and titanium nitride (TiN), instead of polycrystalline silicon.

Then, an insulating layer 37 of silicon dioxide or PSG is formed over the metal guard ring 42, the fuse 35 and the field oxide layer 36 by a CVD process and is selectively etched by lithography to form another groove being the same shape as the above-mentioned groove. A second metal guard ring 41B of, e.g., aluminum is formed by depositing a metal layer and selectively etching it to come into contact with the first metal ring 41A. It is preferable that the formation of the second guard metal ring 413 is carried out at the same time at which other (upper) interconnections (conductive lines) are formed. The second guard ring 41B is jointed to the first guard ring 41A to form a solid metal guard ring 41. Thus, portions of the layers 36 and 37 near the narrow portion 35A are substantially separated from the remaining portions of the layers 36 and 37 with the metal guard ring 41. It is preferable that one of the metal guard rings 41A and 41B is connected with an interconnection (conductive line) for applying a bias voltage to the isolating region 34. It is possible to use aluminum alloy, W, WSi, Ti or TiN as a conductive material of the metal guard ring.

A passivation layer 38 of PSG is formed over the metal guard ring 41 and the insulating layer 37, and is selectively etched to form an opening 40 above the narrow portion 35A. Then, a layer 39 of Si₃N₄ is formed on the passivation layer 38 and within the opening 40 to cover the exposed side of the layer 38 and the exposed portion of the layer 37. The nitride layer 39 is selectively etched to form another opening 42 above the narrow portion 35A in the opening 40, as shown in Fig. 3A. The opening 42 is smaller than the opening 40, so that the nitride layer 39 covers the side of the passivation layer 38 and an interface between the layers 37 and 38, but does not exist above the narrow portion 35A. Thus, the semiconductor device with the fuse is obtained.

The fuse 15 of the semiconductor device is blown by breaking the narrow portion 15A with a laser beam or a pulse current in the conventional manner. Some of a number of the fuses are selectively blown in accordance with demands, while the majority of the fuses are not blown.

According to the present invention, the conductive guard ring 42 vertically extends through the layers 36 and 37 and comes into contact with the substrate 31 (epitaxial layer 33), which prevents moisture from penetrating into the inside of the device through the insulating (hygroscopicity) layer 37, and through cracks caused during blowing and interfaces between the layers 37 and 36 and between the layer 36 and the substrate 31. The nitride layer 39 covers the side of the passivation layer 38 and the interface between the layers 38 and 37 as well as the top surface of the layer 38 to prevent moisture from penetrating through the layer 38 and the interface. Furthermore, the isolation region 34 prevents the short circuit trouble as mentioned in the prior art explanation. Since the metal guard ring 41 comes into contact with the isolation region, when an bias voltage is applied to the isolation region 34 through the metal guard ring 41, an electrical isolation effect of the isolation region is increased. For example, the lowest voltage is applied to the p-type isolation region 34 through the metal guard ring 41 to intensify the isolation effect, which more certainly prevents the short circuit trouble.

### Second Embodiment

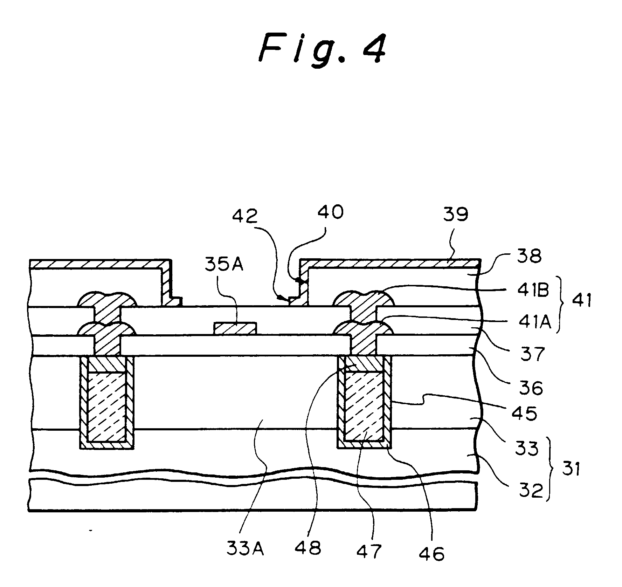

Referring to Fig. 4, a semiconductor device according to a second embodiment of the present invention is similar to the device of the first embodiment except that a trench isolation layer 45 is formed in the substrate instead of the isolation region. Preferably, the trench isolation layer 45 comprises a thin SiO₂ layer 46 formed on a U-groove, a filler 47 of, e.g., polycrystalline silicon and a lid SiO₂ layer 48 of the filler. Reference numerals in Fig. 4 which are the same as those used in Figs. 3A and 3B indicate the same parts or similar parts of the device of Figs. 3A and 3B.

After the growth of the epitaxial layer 33 of the substrate 31, the substrate 31 is selectively and anisotropically etched by, e.g., a reactive ion etching (RIE) process to form a U-groove of a rectangular ring similar to the isolation region 34 (Fig. 3A). The groove extends in a semiconductor base substrate 32. The substrate 31 is thermally oxidized to form the thin SiO₂ layer 46 on the groove surface and at the same time a thin SiO₂ layer (not shown) on the top surface of the epitaxial layer 33. A polycrystalline silicon is deposited over the whole surface to fill the groove and is then removed to leave a portion thereof within the groove as the filler 47. The thin SiO₂ layer formed on the epitaxial layer 33 is removed by an etching process. Next, an upper portion of the filler 47 and the epitaxial layer 33 are thermally oxidized to form the lid SiO₂ layer 48 and the field oxide layer 36. Thus, the trench isolation layer 45 is formed.

As mentioned in the first embodiment, the fuse with the narrow blowable portion 35A, the first metal guard ring 41A coming into contact with the lid SiO₂ layer 48, the insulating layer 37, the second metal guard ring 41B, the passivation layer 38 with the opening 40, and the nitride layer 39 with the opening 42 are formed to produce the semiconductor device.

The metal guard ring 41 consisting of the first and second metal guard ring 41A and 41B and the nitride layer 39 extending into the opening 40 prevent moisture from penetrating into the inside of the device. The trench isolation layer 45 prevents the short circuit trouble. Therefore, the quality of the semiconductor device with a fuse is remarkably improved.

## Claims

1. A semiconductor device with a fuse comprising:
a silicon substrate (31);
a field oxide layer (36) formed on said silicon substrate;
a fuse (35) being a conductor formed on said field oxide layer (36) and having a blowable narrow portion (35A);
an insulating layer (37) of silicon oxide or phosphosilicate glass formed over said fuse (35) and said field oxide layer (36) to isolate said fuse (35) from higher level conductors;
a phosphosilicate glass passivation layer (38) formed on said insulating layer and having an opening above said fuse (35) ;
a silicon nitride layer (39) formed on said passivation layer (38) which completely covers the sidewall of said opening in said passivation layer (38) and an interface between the insulating layer (37) and said passivation layer (38) so as to leave an opening above said blowable narrow fuse portion (35A) which is smaller than the opening in the passivation layer (38); and,
a guard ring (41) formed of an electrically conductive material which surrounds said blowable narrow portion (35A) of said fuse (35), and is formed under said passivation layer (38) to extend from said passivation layer (38) to said silicon substrate (31) through said insulating layer (37) and said field oxide layer (36) without making electrical contact to the fuse, wherein an isolation region (34; 45) of a conductivity type opposite to that of the surrounding silicon substrate (31) or a trench isolation layer of an insulator is formed in the silicon substrate (31) so as to completely surround and isolate a portion of said semiconductor substrate (32) below said blowable narrow portion (35A) whereby said guard ring (41) is in direct contact with and vertically overlaps said isolation region (34; 45).

2. A semiconductor device according to claim 1, wherein said silicon substrate (31) consists of a base semiconductor substrate (32) having a first conductivity and an epitaxial semiconductor layer (33) having a second conductivity, opposite to said first conductivity, wherein the isolation region (34) is formed of said first conductivity in said epitaxial semiconductor layer (33) so as to completely surround and isolate a portion (33A) of said epitaxial layer below said narrow portion (35A).

3. A semiconductor device according to claim 1, wherein said silicon substrate (31) consists of a base semiconductor substrate (32) having a first conductivity and an epitaxial semiconductor layer (33) having a second conductivity, opposite to said first conductivity, wherein said isolation region is formed as a trench isolation layer (45) of an insulator which extends to said base semiconductor substrate (32) through said epitaxial semiconductor layer (33) so as to completely surround and isolate a portion (33A) of said epitaxial layer below said narrow portion (35A).

4. A semiconductor device according to any one of the preceding claims, wherein said fuse (35) is made of polycrystalline silicon, aluminum, tungsten, tungsten silicide, titanium or titanium nitride.

5. A semiconductor device according to any one of the preceding claims, wherein said guard ring (41) is made of aluminium, aluminium alloy or polycrystalline silicon.

## Patentansprüche

1. Halbleitervorrichtung mit einer Sicherung, mit:
einem Siliziumsubstrat (31),
einer Feld-Oxidschicht (36), die auf dem Siliziumsubstrat ausgebildet ist;
einer Sicherung (35) in Form eines Leiters, der auf der Feld-Oxidschicht (36) ausgebildet ist und einen auslösbaren schmalen Abschnitt (35A) besitzt;
einer Isolierschicht (37) aus Siliziumoxid oder aus Phosphorsilikatglas, die über der Sicherung (35) und der Feld-Oxidschicht (36) ausgebildet ist, um die Sicherung (35) gegenüber Leiter in einer höheren Ebene zu isolieren;
einer Phosphorsilikatglas-Passivierungsschicht (38), die auf der Isolierschicht ausgebildet ist und eine Öffnung über der Sicherung (35) aufweist;
einer Siliziumnitridschicht (39), die auf der Passivierungsschicht (38) ausgebildet ist und die die Seitenwand der Öffnung in der Passivierungsschicht (38) und eine Zwischenschicht zwischen der Isolierschicht (37) und der Passivierungsschicht (38) vollständig bedeckt, um eine Öffnung über dem auslösbaren schmalen Sicherungsabschnitt (35A) zu belassen, die kleiner ist als die Öffnung in der Passivierungsschicht (38); und
einem Schutzring (41), der aus einem elektrisch leitenden Material hergestellt ist und den auslösbaren schmalen Abschnitt (35A) der Sicherung (35) umschließt und der unter der Passivierungsschicht (38) ausgebildet ist, so daß er sich von der Passivierungsschicht (38) zu dem Siliziumsubstrat (31) durch die Isolierschicht (37) und die Feld-Oxidschicht (36) erstreckt ohne dabei einen elektrischen Kontakt mit der Sicherung zu schließen, wobei eine Isolierzone (34; 45) eines Leitfähigkeitstyps entgegengesetzt zu demjenigen des umgebenden Siliziumsubstrats (31) ausgebildet ist oder eine Graben-Isolierschicht aus einem Isolator in dem Siliziumsubstrat (31) ausgebildet ist, so daß diese einen Abschnitt des Halbleitersubstrats (32) unter dem auslösbaren schmalen Abschnitt (35A) vollständig umschließt und isoliert, wodurch der Schutzring (41) in direktem Kontakt mit der Isolierzone (34; 45) steht und diese vertikal überlappt.

2. Halbleitervorrichtung nach Anspruch 1, bei der das Siliziumsubstrat (31) aus einem Basis-Halbleitersubstrat (32) mit einer ersten Leitfähigkeit und einer epitaxialen Halbleiterschicht (33) mit einer zweiten Leitfähigkeit, die zur ersten Leitfähigkeit entgegengesetzt ist, besteht, wobei die Isolierzone (34) in der epitaxialen Halbleiterschicht (33) mit der ersten Leitfähigkeit ausgebildet ist, so daß sie einen Abschnitt (33A) der epitaxialen Schicht unter dem schmalen Abschnitt (35A) vollständig umschließt und isoliert.

3. Halbleitervorrichtung nach Anspruch 1, bei der das Siliziumsubstrat (31) aus einem Basis-Halbleitersubstrat (32) mit einer ersten Leitfähigkeit und aus einer epitaxialen Halbleiterschicht (33) mit einer zweiten Leitfähigkeit, die zur ersten Leitfähigkeit entgegengesetzt ist, besteht, wobei die Isolierzone als eine Graben-Isolierschicht (45) eines Isolators ausgebildet ist, die sich zu dem Basis-Halbleitersubstrat (32) durch die epitaxiale Halbleiterschicht (33) hin erstreckt, sc daß sie einen Abschnitt (33A) der epitaxialen Schicht unter dem schmalen Abschnitt (35A) vollständig umschließt und isoliert.

4. Halbleitervorrichtung nach irgendeinem der vorhergehenden Ansprüche, bei der die Sicherung (35) aus polykristallinem Silizium, Aluminium, Wolfram, Wolfram-Silizid, Titan oder Titannitrid hergestellt ist.

5. Halbleitervorrichtung nach irgendeinem der vorhergehenden Ansprüche, bei der der Schutzring (41) aus Aluminium, einer Aluminiumlegierung oder aus polykristallinem Silizium hergestellt ist.

## Revendications

1. Dispositif à semiconducteur avec fusible comprenant :
un substrat en silicium (31) ;
une couche d'oxyde de champ (36) formée sur ledit substrat en silicium ;
un fusible (35) qui est un conducteur formé sur ladite couche d'oxyde de champ (36) et qui comporte une partie étroite grillable (35A) ;
une couche isolante (37) en oxyde de silicium ou en verre de phosphosilicate formée au-dessus dudit fusible (35) et au-dessus de ladite couche d'oxyde de champ (36) pour isoler ledit fusible (35) de conducteurs de niveau supérieur ;
une couche de passivation en verre de phosphosilicate (38) formée sur ladite couche isolante et comportant une ouverture au-dessus dudit fusible (35) ;
une couche en nitrure de silicium (39) formée sur ladite couche de passivation (38), laquelle recouvre complètement la paroi latérale de ladite ouverture ménagée dans ladite couche de passivation (38) et une interface entre la couche isolante (37) et ladite couche de passivation (38) de manière à laisser une ouverture au-dessus de ladite partie de fusible étroite grillable (35A) qui soit plus petite que l'ouverture ménagée dans la couche de passivation (38) ; et
un anneau de garde (41) formé en un matériau électriquement conducteur qui entoure ladite partie étroite grillable (35A) dudit fusible (35) et qui est formé au-dessous de ladite couche de passivation (38) de manière à s'étendre depuis ladite couche de passivation (38) jusqu'audit substrat en silicium (31) au travers de ladite couche isolante (37) et de ladite couche d'oxyde de champ (36) sans réaliser un contact électrique avec le fusible où une région d'isolation (34 ; 45) d'un type de conductivité opposé à celui du substrat en silicium avoisinant (31) ou une couche d'isolation par tranchée d'un isolateur est formée dans le substrat en silicium (31) de manière à entourer et isoler complètement une partie dudit substrat semiconducteur (32) au-dessous de ladite partie étroite grillable (35A) de telle sorte que ledit anneau de garde (41) soit en contact direct avec ladite région d'isolation (34 ; 45) et chevauche verticalement cette même dite région d'isolation.

2. Dispositif à semiconducteur selon la revendication 1, dans lequel ledit substrat en silicium (31) est constitué par un substrat semiconducteur de base (32) présentant une première conductivité et par une couche semiconductrice épitaxiale (33) présentant une seconde conductivité opposée à ladite première conductivité, dans lequel la région d'isolation (34) est formée selon ladite première conductivité dans ladite couche semiconductrice épitaxiale (33) de manière à entourer et isoler complètement une partie (33A) de ladite couche épitaxiale au-dessous de ladite partie étroite (35A).

3. Dispositif à semiconducteur selon la revendication 1, dans lequel ledit substrat en silicium (31) est constitué par un substrat semiconducteur de base (32) présentant une première conductivité et par une couche semiconductrice épitaxiale (33) présentant une seconde conductivité opposée à ladite première conductivité, dans lequel ladite région d'isolation est formée en tant que couche d'isolation par tranchée (45) d'un isolateur qui s'étend jusqu'audit substrat semiconducteur de base (32) au travers de ladite couche semiconductrice épitaxiale (33) de manière à entourer et isoler complètement une partie (33A) de ladite couche épitaxiale au-dessous de ladite partie étroite (35A).

4. Dispositif à semiconducteur selon l'une quelconque des revendications précédentes, dans lequel ledit fusible (35) est réalisé en silicium polycristallin, en aluminium, en tungstène, en siliciure de tungstène, en titane ou en nitrure de titane.

5. Dispositif à semiconducteur selon l'une quelconque des revendications précédentes, dans lequel ledit anneau de garde (41) est réalisé en aluminium, en un alliage d'aluminium ou en silicium polycristallin.
